(19) Europäisches Patentamt
European Patent Office
Office européen des brevets

(11) **EP 1 881 636 A1**

(12) **EUROPEAN PATENT APPLICATION**

(43) Date of publication:
**23.01.2008 Bulletin 2008/04**

(51) Int Cl.:
***H04L 1/06*** (2006.01)

(21) Application number: **07252786.4**

(22) Date of filing: **12.07.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK YU**

(30) Priority: **21.07.2006 GB 0614583**

(71) Applicant: **Kabushiki Kaisha Toshiba**
**Minato-ku, Tokyo 105-8001 (JP)**

(72) Inventors:
• **Andrieu, Christophe**
c/o Toshiba Research Europe Ltd.
Bristol BS1 4ND (GB)

• **Sandell, Magnus Stig Torsten**
c/o Toshiba Research Europe Ltd.
Bristol BS1 4ND (GB)
• **Piechocki, Robert Jan**
c/o Toshiba Research Europe Ltd.
Bristol BS1 4ND (GB)
• **Jia, Yugang**
c/o Toshiba Research Europe Ltd.
Bristol BS1 4ND (GB)

(74) Representative: **Round, Edward Mark**
**Marks & Clerk**
**90 Long Acre**
**London WC2E 9RA (GB)**

(54) **Decoder for wireless communication system**

(57) Information is detected in a signal received from a transmission over a MIMO channel from a plurality of transmit antennas. The information is encoded as QAM symbols over space and time and/or frequency. A method of detection is provided, comprising arranging the available QAM symbols into a hierarchical tree structure, each level of the tree structure providing a greater level of granularity than the previous and, for each level of the tree structure from the least specific onwards, for each selected branch of the tree structure in said level, determining a branch likelihood measure, representing the approximated likelihood of a received signal containing a symbol in said branch, selecting one or more of said branches on the basis of their branch likelihood measures, said selected branches being selected for consideration in the next level of the tree structure, such that, at a last level, wherein each branch thereof corresponds to a symbol, said branch likelihood measure for a branch corresponds to a likelihood of said received signal containing the corresponding symbol. Corresponding detector apparatus is further provided.

Fig. 1

## Description

The invention relates to decoding a transmission from a multiplexing transmitter, particularly but not exclusively in a spatially multiplexed MIMO system.

MIMO communication involves detection at the receiver of symbols borne on the MIMO channel. One popular way of achieving this is by means of a Sphere Decoder (SD). The principle of operation of a sphere decoder is disclosed in "Improved methods for calculating vectors of short lengths in a lattice, including a complexity analysis," (U. Fincke and M. Pohst, Mathematics of Computation, vol. 44, no. 3, pp. 463-471, Apr. 1985).

The complexity of the SD is highly affected by the wireless channel and thus the technique is undesirable for a practical application which allocates fixed memory and computing resources for the detection process.

Another efficient state-of-the-art method is the sequential Gaussian approximation (SGA) algorithm. This has been demonstrated to achieve near optimal performance with the practical constraints of fixed complexity and memory requirements. The key step of the SGA algorithm, which identifies the M most significant symbol combinations, requires the computation and sorting of $MNN_T$ symbol probabilities for a MIMO system with $N_T$ antennas and N-QAM modulation. Although the complexity of the SGA algorithm is less than that of SD, a practical implementation of SGA algorithm for MIMO system with large constellation size (e.g. 16QAM, 64QAM) still involves significant computational cost.

Larger constellation exhibit a multilevel structure, of which use has been made in the past for complexity reduction, in a variety of situations, for instance in D. Guo, X. Wang, and R. Chen, "Multilevel mixture kalman filter," (EURASIP Journal of Applied Signal Processing, vol. 15, pp.2255-2266, Nov 2004), Y.L.C.de Jong and T.J. Willink, "Iterative tree search detection for MIMO wireless systems" (Vol.53, no.6 pp930-935, Jun. 2005. IEEE Trans. On Wireless Communications) and Y.L.C.de Jong and T.J. Willink, "Iterative trellis search detection for asynchronous MIMO systems" (In proc. IEEE VTC'2003,pp503-507, Oct. 2003).

Whereas the original SGA algorithm computes MN approximated symbol probabilities of pseudo symbol combinations and selects M of these with the highest probabilities for $N_T$ antennas, a first aspect of the invention computes 4M approximated symbol probabilities of pseudo symbol combinations and selects M of these with the highest probabilities for log4(N) stages for each antenna in the first iteration.

It will be appreciated that the invention can be embodied by a computer apparatus configured by a computer program executed thereby, to perform any of the methods of the invention, and/or to become configured as apparatus of any aspect of the invention.

In that case, the computer program can be introduced by any practical means, such as by optical or magnetic storage media, by signal received such as through a download implemented by means of the internet, by smartcard, flash memory or other integrated circuit storage means, or by configuration using application specific hardware such as an ASIC.

A specific embodiment of the invention will now be described, by way of example only and with reference to the accompanying drawings, in which:

Figure 1 illustrates a schematic diagram of a MIMO data communications system in accordance with a specific embodiment of the invention;

Figure 2 illustrates a method of identifying significant symbol combinations in accordance with SGA;

Figure 3 illustrates a hierarchical tree arranged QAM constellation in accordance with an exemplary embodiment of the invention;

Figure 4 illustrates the tree structure of the QAM constellation illustrated in figure 3 in further detail;

Figure 5 illustrates a multilevel set of pseudo symbols in accordance with a further exemplary embodiment of the invention;

Figure 6 illustrates a multilevel identification procedure in accordance with the described embodiment of the invention;

Figure 7 illustrates modelled performance characteristics for examples of use of the described embodiment of the invention; and

Figure 8 illustrates a process performed in identification of significant symbol combinations in accordance with the described embodiment of the invention.

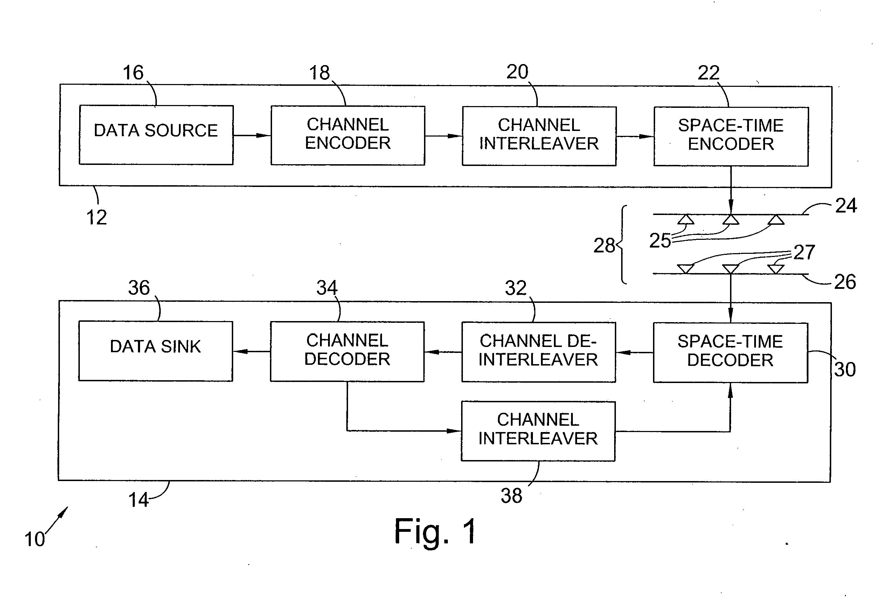

Figure 1 illustrates a MIMO data communications system 10 comprising a transmitter device 12 and a receiver device 14. The transmitter device 12 comprises a data source 16, which provides data (comprising information bits or symbols) to a channel encoder 18. The channel encoder 18 in this example comprises a convolutional coder such as a recursive systematic convolutional (RSC) encoder. The channel encoder 18 operates such that more bits are output from the encoder than are presented to its input, and typically the rate is one half or one third.

The channel encoder presents the encoded bits to a channel interleaver 20, in the illustrated embodiment, a space-time encoder 22. The channel interleaver 20 interleaves the bits into symbols in a manner that ensures that errors do not arise due to repeated transmission of a bit in a certain position in a data frame from the same antenna, or that adjacent bits are separated so that errors due to breaks in transmission are possibly capable of being recovered.

The space-time encoder 22 encodes an incoming symbol or symbols as a plurality of code symbols for simultaneous transmission from a transmitter antenna array 24 comprising a plurality of transmit antennas 25. In this illustrated example, three transmit antennas 25 are provided. In the general case, the number of transmit antennas is designated $N_T$.

The encoded transmitted signals propagate through a MIMO channel 28 defined between the transmit antenna array 24 and a corresponding receive antenna array 26 of the receiver device 16. The receive antenna array 26 comprises $N_R$ receive antennas 27 which provide a plurality of inputs to a space-time (and/or frequency) decoder 30 of the receiver device 16. In this specific embodiment, the receive antenna array 26 comprises three receive antennas 27.

In the general case, it is merely a condition of operability that $N_R \geq N_T$.

The space-time decoder 30 is operable to remove the effect of the encoder 22. The receiver 14 of the specific embodiment is configured with the transmitter 12 in mind. The output of the space-time decoder 30 comprises a plurality of signal streams, one for each transmit antenna 25, each carrying so-called soft or likelihood data on the probability of a transmitted symbol having a particular value. This data is provided to a channel de-interleaver 32 which reverses the effect of the channel interleaver 20 and outputs convolutional code on the basis of the likelihood data provided by the space-time decoder 30.

The convolutional code output by the channel de-interleaver 32 is then presented to a channel decoder 34. In this example, the channel decoder 34 is a Viterbi decoder, which is operable to decode the convolutional code.

The channel decoder 34 is a SISO (soft-in soft-out) decoder, that is operable to receive symbol (or bit) likelihood data and to provide similar likelihood data as an output rather than, say, data on which a hard decision has been made. The output of channel decoder 34 is provided to a data sink 36, for further processing of the data in any desired manner.

The channel decoder 34 further presents its output to a further channel interleaver 38, of equivalent design to the channel interleaver 20 of the transmitter 12, and thus interleaves the decoded received data in the same manner as the original data had been interleaved in the transmitter 12. This interleaved received data is then presented back to the space-time decoder 30, as *a priori* data for use in the space-time decoding process.

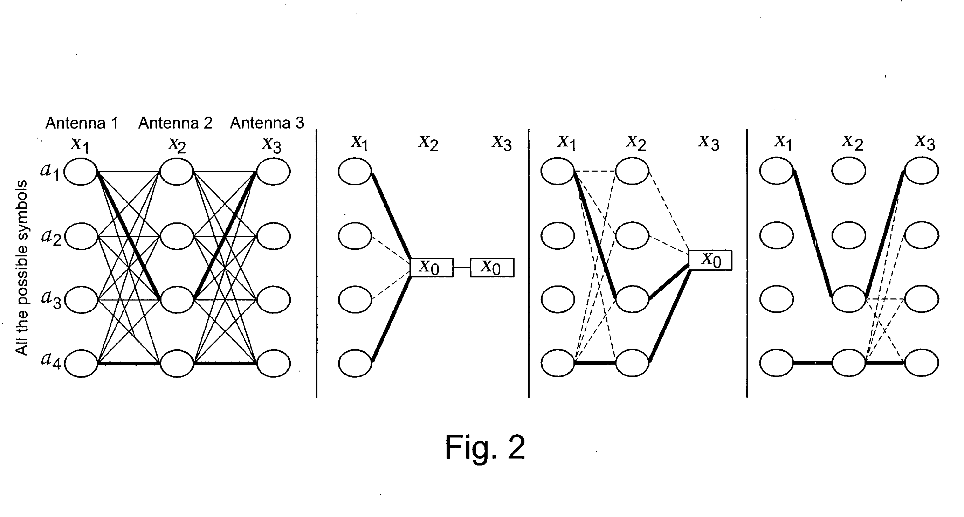

Operation of the space-time decoder 30 will now be described with reference to figure 2 of the drawings. The operation of the space-time decoder 30 enables the decoding of signals modulated using relatively high order modulation schemes, using an average level of complexity associated with a sphere decoder as described and reference above.

For reasons of clarity, the method is described with reference to the general case, with $N_T$ transmit antennas 25 and $N_R$ receive antennas 27. From this description of the general example, operation of the specific illustrated example with three transmit antennas 25 and three receive antennas 27 will be understood.

By way of background information, the manner in which MIMO communication operates will now be described, along with the manner in which symbols are transferred through the MIMO channel 28.

As noted above, in general terms, the spatial multiplexing MIMO system of the embodiment has $N_T$ transmit antennas 25 and $N_R \geq N_T$ receive antennas 27. At each time instant, $N_T$ symbols $\mathbf{x} \overset{\text{def}}{=} \left[ x_1, x_2, \ldots x_{N_T} \right]^T$ (where $[*]^T$ indicates the transpose of a vector or matrix), taken from a modulation constellation $A = \{a_1, a_2, ..., a_N\}$, are transmitted from each transmit antenna 25 of the transmit antenna array 24.

$N_R$ observations $\mathbf{y} \overset{\text{def}}{=} \left[ y_1, y_2, \ldots, y_{N_R} \right]^T$ are correspondingly obtained at the receive antenna array 26. The relationship between $\mathbf{x}$ and $\mathbf{y}$ is:

$$\mathbf{y} = \mathbf{Hx} + \mathbf{n} \qquad\qquad (1)$$

where $\mathbf{H}$ is the $N_R \times N_T$ channel matrix with $h(i,j)$ as its $(i,j)$-th entry. The quantity $h(i,j)$ represents the channel gain from transmit antenna $j$ to receive antenna $i$. Vector $\mathbf{n}$ is an $N_R \times 1$ zero-mean complex circular symmetric Gaussian noise

with covariance matrix $\sigma_n^2 \, \mathbf{I}$ .

In the following analysis, the notation [∗]* and [∗]$^H$ will be used to denote the conjugate and transpose conjugate of a matrix or vector respectively.

The task of the space-time decoder 30 is to estimate the transmitted symbol x from the observation *y* given the channel state information **H**. More precisely, the marginal posterior distribution p($x_j$|**y**, **H**) for *j* = 1,2,...,$N_T$ is desired. In the following description, conditioning on **H** is assumed to be implicit, and is therefore omitted for the clarity of the analysis.

As previously disclosed in UK Patent Application 0426486.7, the SGA algorithm allows approximation of the marginal posterior distributions p($x_j$|**y**). Exact computation of these requires an exhaustive search of all the possible symbol combinations, and this can be efficiently approximated via M most significant symbol combinations:

$$\mathrm{p}(x_j \mid \mathbf{y}) = \sum_{x_{-j} \in D_{-j}} \mathrm{p}(\mathbf{x}_{-j}, x_j|\mathbf{y}) \approx \sum_{m=1}^{M} \mathrm{p}(x_1^{(m)}, \ldots, x_{j-1}^{(m)}, x_j, x_{j+1}^{(m)}, \ldots, x_{N_T}^{(m)}|\mathbf{y}), \qquad (2)$$

where $x_{-j}$ refers to all the antennas except antenna *j* and $D_{-j}$ is the set which contains the $N^{N_T-1}$ possible values of $\mathbf{x}_{-j}$ .

The method by which this is achieved, in accordance with the previously disclosed patent application referred to above, will now be briefly described. It will be appreciated that the selection of these M most significant symbol combinations would in principle require the computation of all the possible symbol combinations and has a prohibitive computation cost which exponentially grows with the number of transmit antennas.

In the SGA algorithm, the selection for θ is decomposed into $N_T$ steps where M most significant symbol combinations arte identified to obtain

$$\Theta_j = \left\{ \left( x_1^{(m)}, \ldots, x_j^{(m)} \right), m = 1, \ldots M \right\} \text{ for } j = 1, 2, \ldots, N_T .$$

In each step, the *MN* approximated likelihoods $\psi_m$ ($x_j$) of all possible combinations $\left\{ \left( x_1^{(m)}, \ldots, x_{j-1}^{(m)}, x_j \right), m = 1, \ldots M, x_j \in A \right\}$ are computed.

Then, M most significant symbol combinations with the largest $\psi_m$ ($x_j$) are selected for $\theta_j$. On the final iteration, when *j* = $N_T$, θ=$\theta_{N_T}$ is the obtained result.

The step of identifying significant symbol combinations in the described SGA algorithm will now be demonstrated by way of example as illustrated in Figure 2. In this example, a lattice representation is illustrated for four possible symbols in a constellation *A* = {$a_1,a_2,a_3,a_4$}, on three transmit antennas (1, 2, 3). Hence $N_T$ = 3, and it is assumed that $N_R \geq 3$. The objective is to identify the M = 2 most significant symbol combinations from the 64 possibilities. The possible symbol combinations are represented by lines in a trellis in Fig. 2(a): the two thick lines indicate the two most significant symbol combinations, i.e. ($a_4$, $a_4$, $a_4$) and *($a_1$, $a_3$, $a_1$)*.

In a first step, where *j* = 1, the approximated likelihood $\psi_0$ ($x_1$) is calculated for $x_1 \in A$ while antennas 2 and 3 are assumed to have transmitted $x_0$ = 0. Assuming that $\psi_0$ ($a_1$) and $\psi_0(a_4)$ are the two largest $\psi_0$ ($x_1$) for $x_1 \in A$, then $\theta_1$ = {$a_1$, $a_4$}. This step is illustrated in Fig. 2(b).

In the second step, where *j* = 2, the eight possible values of $\psi_m(x_2)$ are computed for *m* = 1,2 and $x_2 \in A$ while $x_0$ is assumed transmitted by antenna 3. Assuming that $\psi_1$ ($a_3$) and $\psi_2$ ($a_4$) are the two largest values among the eight possibilities, $\theta_2$ is set to {($a_4,a_4$),($a_1,a_3$)}. This step is illustrated in Fig. 2(c). This procedure is again repeated in order to identify $\theta_3$ as equal to {($a_4$, $a_4$, $a_4$), ($a_1$, $a_3$, $a_1$)}.

The complexity of the identification step of this SGA algorithm depends on the constellation size *N*: the computation and sorting of the *MN* likelihoods for $N_T$ steps.

Higher order *N*-QAM constellations are widely used in the modem communication system to improve the bandwidth efficiency. In such cases, the complexity of the SGA algorithm may become undesirably high, although it will be appreciated that this algorithm will still present lower complexity than that of the SD algorithm.

Fortunately, higher order *N*-QAM constellations naturally exhibit a multilevel structure which has been used for complexity reduction in different processing stages. For instance, "Multilevel mixture Kalman Filter" (D. Guo, X. Wang and R. Chen, EURASIP Journal of Applied Signal Processing, special issue onf pParticule Filtering in Singal Processing, vol. 15, pp. 2255-2266, Nov. 2004) uses this multilevel structure in the context of joint channel estimation and detection for a single user system.

Moreover, "Iterative tree search detection for MIMO wireless systems" (Yvo L. C. de Jong and Tricia J. Willink, Proc. IEEE VTC 2003, pp.503-507, Oct 2003) and ."Iterative trellis search detection for asynchronous MIMO systems" (Yvo L. C. de Jong and Tricia J. Willink, IEEE Trans. Wireless Commun., vol. 53, no. 6, pp. 930-935, Jun 2005) use this in iterative tree search based symbol detection for a MIMO system. However, the ITS decoder does not consider the effect of replacing the true symbol with a pseudo symbol in the calculation of the likelihood. In the described specific embodiment, a penalty term is derived from Gaussian approximation to compensate the mismatching between the pseudo symbols and the true symbols.

The specific embodiment of the invention provides use of the multilevel structure of an *N-QAM* constellation, as will now be described.

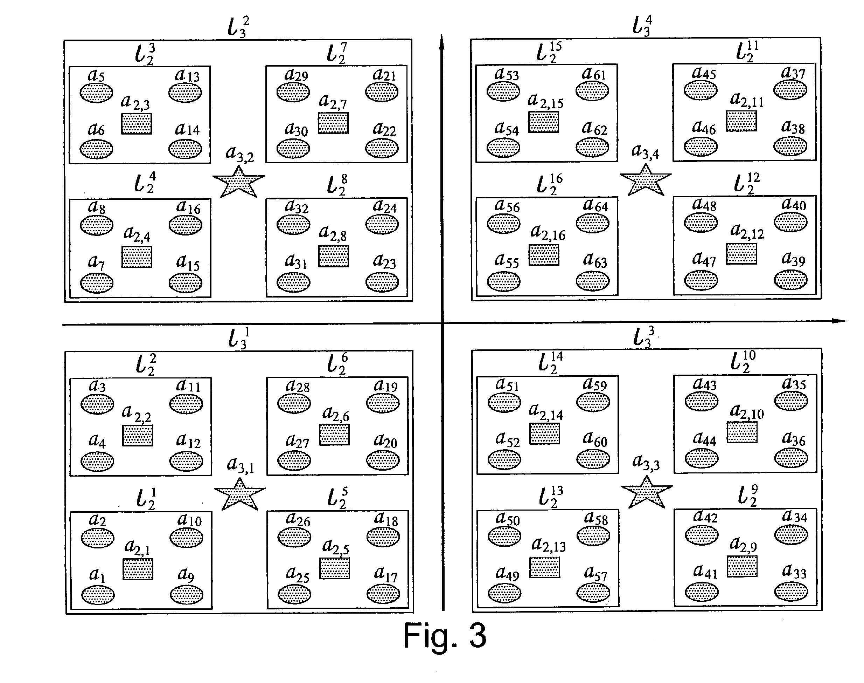

In general terms an *N*-QAM ($N= 4^2, 4^2, ...$) constellation can be considered with $l = 1,...,L$ levels where $L \stackrel{\text{def}}{=} \log_4 N$. It should be noted that, by this approach, the lowest level (when $l = 1$) is *A*. For example, the 64QAM constellation has three levels of hierarchy as illustrated in figure 3.

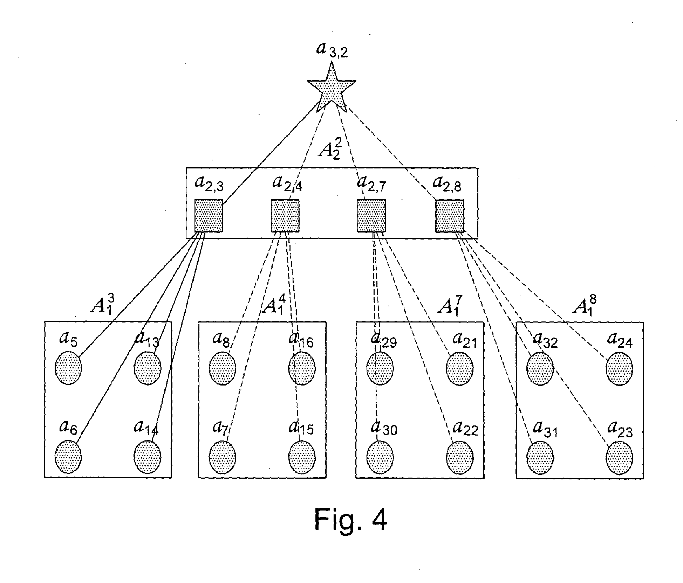

Figure 4 sets out an example of the hierarchical structure of 64QAM. The pseudo symbol $a_{3,2}$ in the highest (third) level is the mean value of $a_{2,3}$, $a_{2,4}$, $a_{2,7}$ and $a_{2,8}$ in the level below, and so on.

For the *l*-th level, the constellation A is divided into $N_1 \stackrel{\text{def}}{=} N4^{1-l}$ subsets $\iota_l^k$ where:

$$\bigcup_k \iota_l^k = A$$

and

$$\iota_l^m \bigcap \iota_l^n = \varnothing,$$

where $m,n = 1,...,N_l$, $m \neq n$.

This example therefore has 64, 16 and 4 subsets for $l = 1, 2, 3$ respectively.

$$l=1:$$

$$\iota_1^k \{a_k\}, k = 1,...,64,$$

$$l=2:$$

$$\iota_2^1 = \{a_1, a_2, a_9, a_{10}\}, \iota_2^2 = \{a_3, a_4, a_{11}, a_{12}\}, \iota_2^3 = \{a_5, a_6, a_{13}, a_{14}\}, \iota_2^4 = \{a_7, a_8, a_{15}, a_{16}\},$$

$$\iota_2^5 = \{a_{17}, a_{18}, a_{25}, a_{26}\}, \iota_2^6 = \{a_{19}, a_{20}, a_{27}, a_{28}\}, \iota_2^7 = \{a_{21}, a_{22}, a_{29}, a_{30}\}, \iota_2^8 = \{a_{23}, a_{24}, a_{31}, a_{32}\},$$

$$\iota_2^9 = \{a_{33}, a_{34}, a_{41}, a_{42}\}, \iota_2^{10} = \{a_{35}, a_{36}, a_{43}, a_{44}\}, \iota_2^{11} = \{a_{37}, a_{38}, a_{45}, a_{46}\}, \iota_2^{12} = \{a_{39}, a_{40}, a_{47}, a_{48}\},$$

$$\iota_2^{13} = \{a_{49}, a_{50}, a_{57}, a_{58}\}, \iota_2^{14} = \{a_{51}, a_{52}, a_{59}, a_{60}\}, \iota_2^{15} = \{a_{53}, a_{54}, a_{61}, a_{62}\}, \iota_2^{16} = \{a_{55}, a_{56}, a_{63}, a_{64}\},$$

$l$=3:

$$\iota_3^1 = \{a_1, a_2, a_9, a_{10}, a_5, a_6, a_{13}, a_{14}, a_{17}, a_{18}, a_{25}, a_{26}, a_{19}, a_{20}, a_{27}, a_{28}\},$$

$$\iota_3^2 = \{a_3, a_4, a_{11}, a_{12}, a_5, a_6, a_{13}, a_{14}, a_{21}, a_{22}, a_{29}, a_{30}, a_{23}, a_{24}, a_{31}, a_{32}\},$$

$$\iota_3^3 = \{a_{33}, a_{34}, a_{41}, a_{42}, a_{35}, a_{36}, a_{43}, a_{44}, a_{49}, a_{50}, a_{57}, a_{58}, a_{51}, a_{52}, a_{59}, a_{60}\},$$

$$\iota_3^4 = \{a_{37}, a_{38}, a_{45}, a_{46}, a_{39}, a_{40}, a_{47}, a_{48}, a_{53}, a_{54}, a_{61}, a_{62}, a_{55}, a_{56}, a_{63}, a_{64}\},$$

The pseudo symbols $a_{l,s}$ and their pseudo prior information $p(a_{l,s})$ for each subset $\iota_l^s$, where $l = 1,...,L$, $s = 1,...,N_l$, are defined as follows:

$$a_{l,s} = 4^{1-l} \sum_{a_k \in \iota_l^s} a_k \tag{3}$$

$$p(a_{l,s}) = \sum_{a_k \in \iota_l^s} p(a_k)$$

and $A_l \stackrel{def}{=} \{a_{l,1},..., a_{l,N_l}\}$ the $l$-th level pseudo symbol set.

The set $A_l$ can also be decomposed into $N_{l+1}$ subsets $A_l^k$, such that

$$\bigcup_k A_l^k = A$$

and

$$A_l^m \bigcap A_l^n = \varnothing, \text{ for } m,n = 1,...,N_{l+1}, \; m \neq n, \text{ for } l = 1,...,L-1.$$

The s-th element $a_{s,l+1} \in A_{l+1}$ is also the centre of the elements in the corresponding subset :

$$a_{l+1,s} = 0.25 \sum_{a_{l,k} \in A_l^s} a_{l,k}$$

For the 64QAM constellation, the above analysis therefore becomes:

$$A_1 = \bigcup_{k=1}^{16} A_l^k = A$$

$$A_l^k = \iota_2^k, k = 1, \dots 16$$

$$A_2 = \bigcup_{k=1}^{4} A_2^k = \{a_{2,1}, \dots, a_{2,16}\}$$

and therefore

$$A_2^1 = \{a_{2,1}, a_{2,2}, a_{2,5}, a_{2,6}\}, \; A_2^2 = \{a_{2,3}, a_{2,4}, a_{2,7}, a_{2,8}\}, \; A_2^3 = \{a_{2,9}, a_{2,10}, a_{2,13}, a_{2,14}\}$$

and

$$A_2^4 = \{a_{2,11}, a_{2,12}, a_{2,15}, a_{2,16}\};$$

and

$$A_3 = \{a_{3,1}, \dots, a_{3,4}\}$$

As explained in de Jong et al.(1), the above partition produces squared subsets with minimum Euclidean distance. Using the multilevel structure of the 64QAM modulation, the selection step in SGA is decomposed into 3 steps where only 4M symbols are searched in each step. In the first step, all the third level pseudo symbols $\{a_{3,1}, \dots, a_{3,4}\}$ will be searched and some will be selected for next step. In the second step only 4M second level pseudo symbols which are related to the selected higher level ones are considered.

In the next step, if, in the previous step, $a_{3,2}$ were selected, then only the pseudo symbols $\{a_{2,3}, a_{2,4}, a_{2,7}, a_{2,8}\}$ are considered. In this step, only 4M symbols which are related to the selected second level ones are considered.

Then, in the next step, if $a_{2,3}$ were selected in the previous step, then only the symbols $\{a_5, a_6, a_{13}, a_{14}\}$ are considered. As a result, the number of computations is reduced from 64M to 12M via a multilevel strategy which will be explained below.

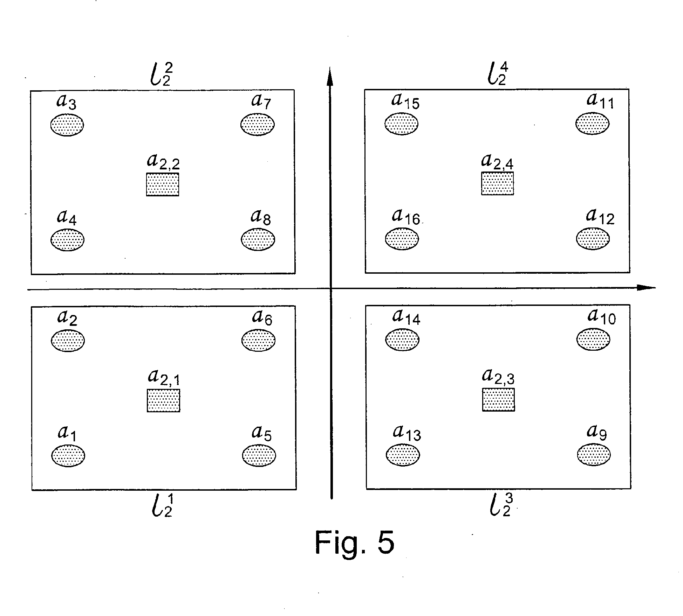

Similarly, a set of multilevel pseudo symbols can be constructed for 16QAM as shown in figure 5:

$$\iota_1^k = \{a_k\}, k = 1, \dots 16$$

$$\iota_2^1 = \{a_1, a_2, a_5, a_6\}, \iota_2^2 = \{a_3, a_4, a_7, a_8\}, \iota_2^3 = \{a_9, a_{10}, a_{13}, a_{14}\}, \iota_2^4 = \{a_{11}, a_{12}, a_{15}, a_{16}\},$$

$$A_1 = A = \bigcup_{k=1}^{4} A_1^k, \; A_1^k = \iota_2^k, \; k = 1, \dots, 4,$$

$$A_2 = \left\{ a_{2,1}, \ldots, a_{2,4} \right\}$$

For a multilevel sequential Gaussian approximation, the initial focus is on obtaining $\theta_j$ for the j-th identification step. It should be noted that in the SGA algorithm, it is necessary to compute and sort *MN* likelihoods.

In contrast, with the multilevel structure of the *N*-QAM constellation, this step is decomposed further into $l = \log_4 N, \ldots, 1$ stages. At each stage, the M most significant pseudo symbol combinations are identified to obtain

$$\Theta_j^l = \left\{ \left( x_1^{(m)}, \ldots, x_{j-1}^{(m)}, x_{j,l}^{(m)} \right), m = 1, \ldots M, x_{j,l}^{(m)} \in A_l \right\} \text{ for } l = L, \ldots, 1.$$

Initially, the 4*M* approximated likelihoods $\psi_m(x_{j,L})$ of all possible combinations of *M* elements in $\theta_{j-1}$, and four symbols in $A_L$ are computed according to equation 5 as set out below. Then, the M most significant pseudo symbol combinations $\Theta_j^l$ with the largest likelihoods $\psi_m(x_{j,L})$ are selected. Then, the process moves down until the lowest modulation level $l = 1$ is reached.

It will be noted that, at each level *l*, only 4M pseudo symbol combinations $\left( x_1^{(m)}, \ldots, x_{j-1}^{(m)}, x_{j,l} \right)$ are considered where $x_{j,l} \in A_l^m$ such that the mean of the elements in

$$A_l^m \text{ is } x_{j+1}^{(m)}:$$
$$0.25 \sum_{x_{j,l} \in A_l^m} x_{j,l} = x_{j,l+1}^{(m)}$$

for m = 1,...,*M*.

At the last stage, where $l = 1$, the set of M most significant symbol combinations

$$\Theta_j = \left\{ \left( x_1^{(m)}, \ldots, x_j^{(m)} \right), m = 1, \ldots M \right\} \text{ is obtained.}$$

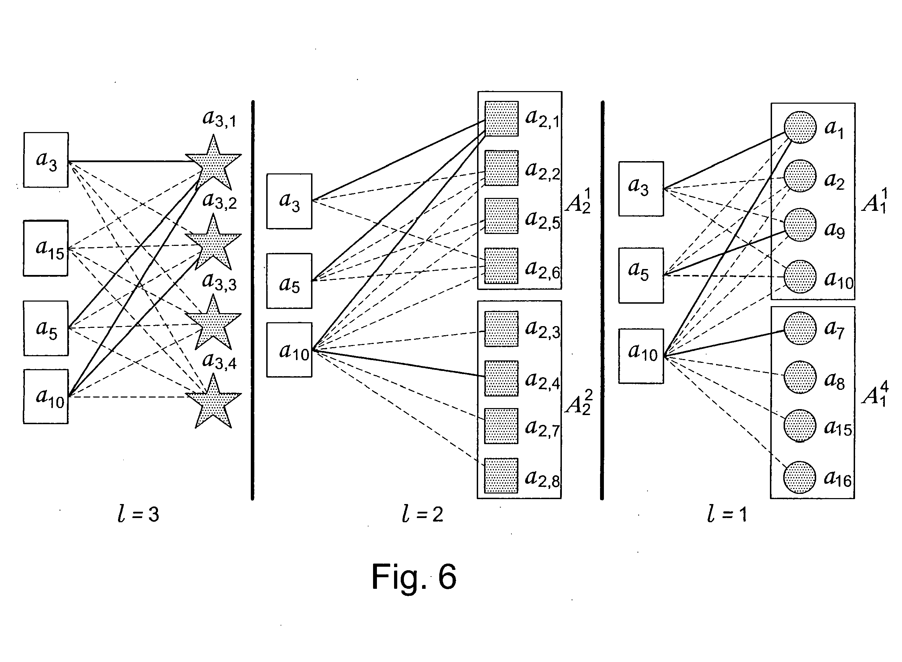

Figure 6 shows an example of the multilevel identification procedure, assuming that the symbols for antenna 1 have been identified as $\Theta_1 = \{a_3, a_{15}, a_5, a_{10},\}$ for *M*= 4 and 64QAM case. The multilevel identification procedure is to be performed for the 2nd antenna to obtain $\Theta_2$.

Instead of computing and sorting $4 * 64$ approximated likelihoods $\psi_m(x_2)$ for symbol combinations $(a_3, a_1),\ldots, (a_3, a_{64}), (a_{15}, a_1),\ldots, (a_{10}, a_{64})$, which would be required in the SGA algorithm, the MSGA algorithm only involves the computation and sorting of 4M approximated likelihoods for three steps as follows.

For the first stage where $l = 3$, the 16 quantities $\psi_m(x_{2,3})$ are calculated for $(a_3, x_{2,3}), (a_{15}, x_{2,3}), (a_5, x_{2,3}), (a_{10}, x_{2,3})$ where $x_{2,3} \in A_3$. It is assumed that $\psi_1(a_{3,1}), \psi_3(a_{3,1}), \psi_4(a_{3,1})$, and $\psi_4(a_{3,2})$ are the four largest quantities, and then

$$\Theta_2^3 = \{ (a_3, a_{3,1}), (a_5, a_{3,1}), (a_{10}, a_{3,1}), \quad (a_{10}, a_{3,2}) \} \text{ is obtained. In the next level } (l = 2), \text{ the 16 quantities } \psi_m(x_{2,3})$$

are calculated, for $(a_3, x_{2,2}), (a_{15}, x_{2,2}), (a_{10}, x_{2,2})$ and $(a_{10}, x_{2,2})$, where $x_{2,2} \in A_2^1$ and $x_{2,2}' \in A_2^2$. It will be noted by the skilled practitioner, that $a_{3,1}$ is the mean of all elements in $A_2^1$ and $a_{3,2}$ is the mean of all the elements in $A_2^2$ respectively.

Then the selection is repeated and $\Theta_2^2 = \{ (a_3, a_{2,1}), (a_5, a_{2,1}), (a_{10}, a_{2,1}), (a_{10}, a_{2,4}) \}$ is obtained. Finally, the above calculation and selection procedure is again repeated in order to identify $\theta_2 = \{(a_3, a_1), (a_5, a_9), (a_{10}, a_1), (a_{10}, a_7)\}$.

The described multilevel approach involves the computation and sorting of 4M approximated likelihoods for

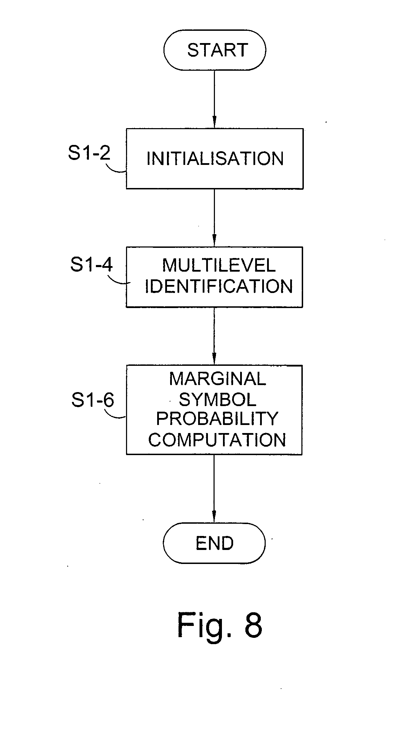

$\log_4 N$ levels, which is only 1/2 and 3/16 of that of the selection procedure in the SGA algorithm for 16QAM and 64QAM modulation constellations respectively. The approach is exemplified below in general terms with reference to figure 8.

*A. Initialization*

In step S1-2, the zero forcing output $\tilde{y}$, variance matrix $\Lambda$, the variance of the pseudo symbol alphabet $A_l \gamma_l$, for $l = 1,...,\log_4 N$ and the variance of $A$ are computed as follows:

$$\tilde{\mathbf{y}} = (\mathbf{H}^H \mathbf{H})^{-1} \mathbf{H}^H \mathbf{y}$$

$$\Lambda = \sigma_n^2 (\mathbf{H}^H \mathbf{H})^{-1}$$

$$\gamma_l = 4^{l-1} \sum_{a_k \in l'_l} |a_k - a_{l,1}|^2$$

$$\gamma = 1/N \sum_{a_k \in A} |a_k|^2$$

and the set of symbol combinations $\theta_0$ is initialised as an empty set, with $\tilde{M} = 0$ and $L = \log_4 N$.

*B. Multilevel identification step for j = 1, ...,$N_T$*

In step S1-4, $\psi_m(x_{j,L})$ is computed according to equation (5) below for $x_{j,L} \in A_L$ and $m = 1,...,M$, then $M = \min (M, 4^{(j-1)L+1})$ symbol combinations are selected which have the largest $\psi_m(x_{j,L})$ for set $\Theta_j^L = \{(x_1^{(m)},..., x_{j-1}^{(m)}, x_{j,L}^{(m)}), m = 1,...,\tilde{M}\}$:

$$\psi_m(x_{j,l}) = \exp\left(\left(\mathbf{w}_j^{(m)}\right)^H \Pi_j^{-1} \mathbf{w}_j^{(m)} - 2\Re\left(\beta_j^{(m)} x_{j,l}\right) + |x_{j,l}|^2 \left[\Pi_j^{-1}\right]_{jj} - \varpi_{j,l}^{(m)}\right) p(x_{j,l}) \prod_{k=1}^{j-1} p(x_k^{(m)})$$

$$\tag{5}$$

$$\varpi_{j,l}^{(m)} = \left(\left|\beta_j^{(m)}\right|^2 - 2\Re\left(\beta_j^{(m)} \left[\Pi_j^{-1}\right]_{jj} x_{j,l}\right) + |x_{j,l}|^2 \left|\left[\Pi_j^{-1}\right]_{jj}\right|^2\right) \Big/ \left(\gamma_l^{-1} + \left[\Pi_j^{-1}\right]_{jj}\right)$$

$$\mathbf{w}_j^{(m)} = \tilde{y} - \sum_{k=1}^{j-1} x_k^{(m)} \mathbf{e}_k$$

$$\Pi_j = \Lambda + \gamma \sum_{k=j+1}^{N_T} \mathbf{e}_k \mathbf{e}_k^T$$

$$\beta_j^{(m)} = (w_j^{(m)})^H \Pi_j^{-1} \mathbf{e}_j$$

The probabilities $p(x_j)$ are the prior information for $j = 1,...,N_T$. The vector $\mathbf{e}_k$ is a column vector whose elements are all zeroes, but the $k$-th which is 1. $\Re$ (*) means the real part of a complex number. $[\mathbf{\Pi}_j^{-1}]_{jj}$ means the $j$-th diagonal element of matrix $\mathbf{\Pi}_j^{-1}$.

It should be noted that the penalty term $\varpi_{j,l}^{(m)}$ is derived from Gaussian approximation to compensate the mismatching between the multilevel pseudo symbols $x_{j,l} \in A_l$ and the actual transmitted symbols which takes value in A.

a) For $l=L-1,...,1$, compute $\psi_m(x_{j,l})$ according to Eq. (5), for $x_{j,l} \in A_l^m$ such that

$$0.25 \sum_{x_{j,l} \in A_l^m} x_{j,l} = x_{j,l+1}^{(m)} \text{ for } m = 1,...,M.$$

b) Select the $M= \min(M, 4^{jL-l+1})$ symbol combinations which have the largest $\psi_m(x_{j,l})$ for $\Theta_j^l$.

*C. Computation of marginal symbol probabilities for $j = 1,...,N_T$*

In step S 1-6, marginal symbol probabilities are computed for the symbols $x_j$.

1)For $m = 1,...,M$ and $x_j \in A$ compute

$$\phi_m(x_j) = \exp(-(\mathbf{Hv})^H \mathbf{Hv}/\sigma_n^2 p(x_j) \prod_{k=j} p(x_k^{(m)}) \tag{6}$$

with $\mathbf{v} = \tilde{\mathbf{y}} - [\mathbf{x}_1^{(m)},..., \mathbf{x}_{j-1}^{(m)}, \mathbf{x}_j, \mathbf{x}_{j+1}^{(m)},..., \mathbf{x}_{N_T}^{(m)}]^T$

2) Compute the symbol probabilities for $x_j \in A$,

$$p(x_j|\mathbf{y}) = \sum_m \phi_m(x_j) / \sum_{x_j} \sum_m \phi_m(x_j).$$

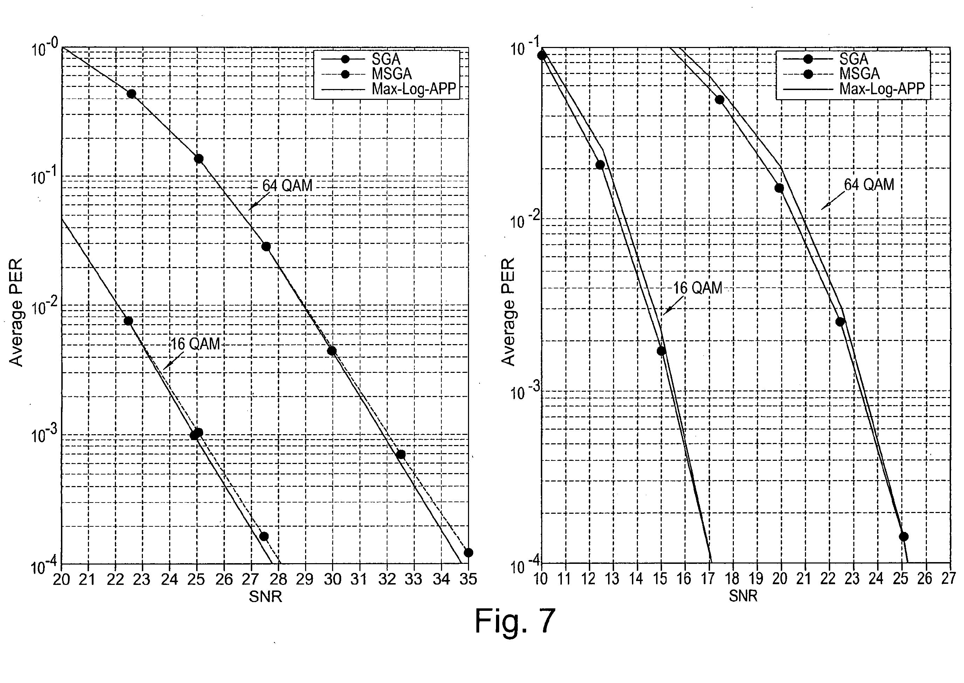

In simulations of implementation of these methods, it has been observed that both of the algorithms achieve the near optical performance (Max-Log APP) where the complexity of Multilevel SGA is only around 70% and 30% of that of the original SGA algorithm for 16QAM and 64QAM modulation MIMO system ($N_T = N_R = 4$) respectively. This is illustrated in figure 7.

It will be appreciated that, in many circumstances, a wireless communications device will be provided with the facilities of a transmitter and a receiver in combination but, for this example, the devices have been illustrated as one way communications devices for reasons of simplicity.

The specific modulation scheme used in the illustrated example is not described, as the number of possible symbols, and the relationship between the symbols (which determines the manner in which symbols are distinguished), are not relevant to the performance of this invention. However, it will be appreciated that the described embodiment can employ BPSK or QPSK, but also the present invention can be applied to higher order modulation schemes with little degradation of performance or computational complexity.

Whereas the present invention has been described with reference to a convolutional channel encoder, it will be appreciated that the invention can be implemented with regard to a stronger encoder such as a so-called turbo encoder (which includes an interleaver).

While the present invention has been described in terms of hardware providing transmitter and receiver functions respectively, it will be appreciated that some, or all, of the apparatus to perform and/or provide the invention may be implemented by means of software directing the operation of a general purpose computer, perhaps suitably configured by hardware to establish wireless communication.

Software to provide implementation of the invention may be provided as a software product, to be loaded onto suitable apparatus to provide the invention. The software product may comprise a data carrier, which may include a magnetic storage device, e.g. a disk or tape, an optical storage device, e.g. an optical disk, for example a Compact Disk or DVD format, or a signal carrying data, e.g. from a storage location remotely accessed and in communication with a device to which the signal is directed, such as via the internet.

**Claims**

1. A method of detecting information carried in a signal received from a transmission over a MIMO channel from a plurality of transmit antennas, the information being encoded as QAM symbols over space and time and/or frequency, the method comprising the steps of:

    arranging the available QAM symbols into a hierarchical tree structure, each level of the tree structure providing a greater level of granularity than the previous and, for each level of the tree structure from the least specific onwards:
    for each selected branch of the tree structure in said level, determining a branch likelihood measure, representing the approximated likelihood of a received signal containing a symbol in said branch, selecting one or more of said branches on the basis of their branch likelihood measures, said selected branches being selected for consideration in the next level of the tree structure;
    such that, at a last level, wherein each branch thereof corresponds to a symbol, said branch likelihood measure for a branch corresponds to a likelihood of said received signal containing the corresponding symbol.

2. A method in accordance with claim 1 wherein the step of determining a branch likelihood measure comprises determining the likelihood of said received signal containing a branch pseudo symbol, a branch pseudo symbol for a branch being a function of the symbols represented by said branch.

3. A method in accordance with claim 2 wherein a branch pseudo symbol is the mean of the symbols represented by said branch.

4. A method in accordance with any preceding claim wherein the step of selecting one or more branches comprises selecting a plurality of said branches, said plurality being less than the total number of branches under consideration.

5. A method in accordance with any preceding claim wherein the step of selecting comprises selecting branches having the highest branch likelihood measure of the branch likelihood measures determined in said determining step.

6. A method of communicating information in a MIMO system, comprising a transmitter having a plurality of transmit antennas and a receiver comprising a plurality of receive antennas, comprising encoding information as symbols, each symbol being a member of a set of permitted symbols, and transmitting the symbols at the transmit antennas modulated in accordance with space and time and/or frequency, then decoding the information at the receiver in accordance with the method of detecting information of any of claims 1 to 5.

7. A decoder for decoding information borne on a signal received from a transmission over a MIMO channel from a plurality of transmit antennas, the signal being received on a plurality of receive antennas, the information being encoded as a string of QAM symbols over space and time and/or frequency, comprising:

means for storing a hierarchical tree structure of the available QAM symbols, each level of the tree structure providing a greater level of granularity than the previous:

means for determining, for each level in the tree and for each selected branch of the tree structure in said level, a branch likelihood measure, representing the approximated likelihood of a received signal containing a symbol in said branch, and

means for selecting one or more of said branches on the basis of their branch likelihood measures, said selected branches being selected for consideration in the next level of the tree structure;

such that, at a last level, wherein each branch thereof corresponds to a symbol, said branch likelihood measure for a branch corresponds to a likelihood of said received signal containing the corresponding symbols, said selecting means thereby selecting one or more symbols for consideration and for determination of a likelihood measure.

8. A MIMO communications system, comprising a transmitter having a plurality of transmit antennas operable to encode information as symbols, each symbol being a member of a set of permitted symbols, and to transmitting the symbols at the transmit antennas modulated in accordance with space and time and/or frequency, and a receiver comprising a plurality of receive antennas, operable to decoding the information, and the receiver comprising a decoder in accordance with claim 7.

9. A computer program product storing computer readable instructions, operable to cause a general purpose computer communication apparatus to become configured to perform a method in accordance with any of claims 1 to 6.

10. A signal carrying computer readable instructions, operable to cause a general purpose computer communication apparatus to become configured to perform a method in accordance with any of claims 1 to 6.

Fig. 1

EP 1 881 636 A1

Fig. 2

EP 1 881 636 A1

Fig. 3

Fig. 4

Fig. 5

Fig. 6

Fig. 7

EP 1 881 636 A1

START

S1-2 | INITIALISATION

S1-4 | MULTILEVEL IDENTIFICATION

S1-6 | MARGINAL SYMBOL PROBABILITY COMPUTATION

END

Fig. 8

**European Patent Office**

**EUROPEAN SEARCH REPORT**

Application Number

EP 07 25 2786

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2005/141644 A1 (SADOWSKY JOHN S [US]) 30 June 2005 (2005-06-30) * paragraphs [0053], [0077] - [0082], [0094] - [0102] * | 1-10 | INV. H04L1/06 |
| A | YUGANG JIA ET AL: "Joint channel tracking and symbol detection in mimo systems via multiple model methods" SIGNAL PROCESSING ADVANCES IN WIRELESS COMMUNICATIONS, 2005 IEEE 6TH WORKSHOP ON NEW YORK, NY, USA JUNE 2-8, 2005, PISCATAWAY, NJ, USA,IEEE, 2 June 2005 (2005-06-02), pages 12-16, XP010834301 ISBN: 0-7803-8867-4 * the whole document * | 1-10 | |
| A | US 2005/050072 A1 (WIDDUP BENJAMIN JOHN [AU] ET AL) 3 March 2005 (2005-03-03) * the whole document * | 1-10 | |
| A,D | DE JONG Y L C ET AL: "Iterative trellis search detection for asynchronous MIMO systems" VEHICULAR TECHNOLOGY CONFERENCE, 2003. VTC 2003-FALL. 2003 IEEE 58TH ORLANDO, FL, USA 6-9 OCT. 2003, PISCATAWAY, NJ, USA,IEEE, US, 6 October 2003 (2003-10-06), pages 503-507Vol1, XP010700994 ISBN: 0-7803-7954-3 * section III. * | 1-10 | TECHNICAL FIELDS SEARCHED (IPC) H04L |

-/--

The present search report has been drawn up for all claims

| Place of search | Date of completion of the search | Examiner |
|---|---|---|
| Munich | 5 November 2007 | Belloni, Paolo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 1 881 636 A1**

European Patent Office

## EUROPEAN SEARCH REPORT

Application Number

EP 07 25 2786

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A,D | DE JONG Y L C ET AL: "Iterative tree search detection for mimo wireless systems"<br>VTC 2002-FALL. 2002 IEEE 56TH. VEHICULAR TECHNOLOGY CONFERENCE PROCEEDINGS. VANCOUVER, CANADA, SEPT. 24 - 28, 2002, IEEE VEHICULAR TECHNOLGY CONFERENCE, NEW YORK, NY : IEEE, US,<br>vol. VOL. 1 OF 4. CONF. 56,<br>24 September 2002 (2002-09-24), pages 1041-1045, XP010608973<br>ISBN: 0-7803-7467-3<br>* section III. *<br>----- | 1-10 | |
| | | | **TECHNICAL FIELDS SEARCHED (IPC)** |

The present search report has been drawn up for all claims

| Place of search | Date of completion of the search | Examiner |
|---|---|---|
| Munich | 5 November 2007 | Belloni, Paolo |

EPO FORM 1503 03.82 (P04C01)

**EP 1 881 636 A1**

## ANNEX TO THE EUROPEAN SEARCH REPORT
## ON EUROPEAN PATENT APPLICATION NO.

EP 07 25 2786

This annex lists the patent family members relating to the patent documents cited in the above-mentioned European search report.
The members are as contained in the European Patent Office EDP file on
The European Patent Office is in no way liable for these particulars which are merely given for the purpose of information.

05-11-2007

| Patent document cited in search report | | Publication date | Patent family member(s) | | Publication date |
|---|---|---|---|---|---|
| US 2005141644 | A1 | 30-06-2005 | CN | 1902867 A | 24-01-2007 |
| | | | EP | 1704692 A1 | 27-09-2006 |
| | | | JP | 2007514382 T | 31-05-2007 |
| | | | WO | 2005067241 A1 | 21-07-2005 |
| US 2005050072 | A1 | 03-03-2005 | NONE | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

• GB 0426486 A

### Non-patent literature cited in the description

• **U. FINCKE ; M. POHST.** Improved methods for calculating vectors of short lengths in a lattice, including a complexity analysis. *Mathematics of Computation,* April 1985, vol. 44 (3), 463-471
• **D. GUO ; X. WANG ; R. CHEN.** Multilevel mixture kalman filter. *EURASIP Journal of Applied Signal Processing,* November 2004, vol. 15, 2255-2266
• **Y.L.C.DE JONG ; T.J. WILLINK.** Iterative tree search detection for MIMO wireless systems. *IEEE Trans. On Wireless Communications,* June 2005, vol. 53 (6), 930-935
• **Y.L.C.DE JONG ; T.J. WILLINK.** Iterative trellis search detection for asynchronous MIMO systems. *proc. IEEE VTC'2003,* October 2003, 503-507

• **D. GUO ; X. WANG ; R. CHEN.** Multilevel mixture Kalman Filter. *EURASIP Journal of Applied Signal Processing, special issue onf pParticule Filtering in Singal Processing,* November 2004, vol. 15, 2255-2266
• **YVO L. C. DE JONG ; TRICIA J. WILLINK.** Iterative tree search detection for MIMO wireless systems. *Proc. IEEE VTC 2003,* October 2003, 503-507
• **YVO L. C. DE JONG ; TRICIA J. WILLINK.** Iterative trellis search detection for asynchronous MIMO systems. *IEEE Trans. Wireless Commun,* June 2005, vol. 53 (6), 930-935